# EUROPÄISCHE PATENTSCHRIFT

(11) **EP 1 723 434 B1**
(45) Veröffentlichungstag und Bekanntmachung des Hinweises auf die Patenterteilung: **14.05.2014**
(21) Anmeldenummer: 05733626.5
(22) Anmeldetag: 07.03.2005
(51) Int. Cl.: G01P 3/481, G01V 3/10, H03K 17/95

(54) **VERFAHREN UND VORRICHTUNG ZUR BERÜHRUNGSLOSEN DREHZAHLMESSUNG**
METHOD AND DEVICE FOR MEASURING SPEED IN A CONTACTLESS MANNER
PROCEDE ET DISPOSITIF POUR MESURER UNE VITESSE DE ROTATION SANS CONTACT

(30) Priorität: 08.03.2004 DE 102004011536; 27.09.2004 DE 102004047116
(43) Veröffentlichungstag der Anmeldung: 22.11.2006
(73) Patentinhaber: Micro-Epsilon Messtechnik GmbH & Co. KG, 94496 Ortenburg (DE)
(72) Erfinder: HRUBES, Franz, 94094 Rotthalmünster (DE)
(74) Vertreter: Naumann, Ulrich
(86) Internationale Anmeldenummer: PCT/DE2005/000396
(87) Internationale Veröffentlichungsnummer: WO 2005/088316

(56) Entgegenhaltungen:
- EP-A- 0 697 769
- EP-A- 0 759 657
- WO-A-98/05919
- DE-A1- 2 649 366
- DE-A1- 4 212 363
- US-A- 4 021 681
- US-A- 4 088 022
- US-A- 4 453 145
- US-A- 4 459 561
- US-A- 5 041 856

## Beschreibung

Die Erfindung betrifft ein Verfahren und eine Vorrichtung zur berührungslosen Drehzahlmessung von Turbinen mit einem nach dem Wirbelstromprinzip arbeitenden Näherungssensor, wobei der Näherungssensor eine Induktivität und eine parallel geschaltete Kapazität umfasst, die einen von außen erregbaren Schwingkreis bilden, und wobei die Resonanzfrequenz des Schwingkreises bei Annäherung eines Messobjekts an den Näherungssensor eine nachweisbare Änderung erfährt. Die Erfindung betrifft ferner eine entsprechende Vorrichtung.

Erfahrungsgemäß ist das vorteilhafteste Messprinzip zur berührungslosen Drehzahlmessung von schnell rotierenden Turbinen, speziell von Turboladern, die Erfassung jeder einzelnen Turbinenschaufel durch einen nach dem Wirbelstromverlustprinzip arbeitenden Sensor. Die Vorteile eines derartigen Verfahrens ergeben sich u. a. daraus, dass zum einen schon bei extrem niedrigen Drehzahlen ein Messsignal vorhanden ist und zum anderen die zulässige höchste Drehzahl theoretisch beliebig hoch ist. Dies ist wichtig, da bei modernen Turboladern - je nach Ladergröße - mit Drehzahlen von bis zu 400.000 Umdrehungen pro Minute zu rechnen ist. Am Außendurchmesser der Rotoren können dabei Umfangsgeschwindigkeiten von über 600 m/s auftreten. Die Messung erfolgt zudem nahezu verzögerungsfrei.

Weitere Vorteile eines berührungslosen Messverfahrens nach dem Wirbelstromprinzip sind darin begründet, dass der Wirkungsgrad des Turboladers nicht beeinträchtigt wird und nur ein minimaler Eingriff in die Geometrie des Laders erforderlich ist. Zudem ist das Messprinzip schmutzunempfindlich, es treten keine Dichtungsprobleme auf und die an der Verdichterseite des Turboladers auftretenden Temperaturen von -40° C bis +200° C sind problemlos beherrschbar.

Sowohl Turbinen im Allgemeinen als auch Turbolader im Speziellen sind - je nach Einsatzgebiet - in den unterschiedlichsten Baugrößen bekannt. Ladergrößen reichen im Normalfall von etwa 25 mm Durchmesser des Verdichterrades bei kleinen PKW-Motoren bis über 200 mm bei Nutzfahrzeugen. Gängige Schaufeldicken reichen dabei von etwa 0,2 mm bis 2 mm. Aus den genannten Abmessungen resultieren Erfassungsabstände zwischen den einzelnen Schaufeln von etwa 0,2 mm bis 2 mm.

Zusätzlich zu den unterschiedlichen Geometrien, Abmessungen und Dimensionierungen der existierenden Turbolader sind Unterschiede in der materiellen Beschaffenheit zu berücksichtigen. Während bei den meisten Turboladern die Schaufeln noch aus Aluminium hergestellt sind, kommt in zunehmendem Maße auch Titan zum Einsatz. Im Normalfall muss die Sensorausführung daher an die jeweilige Bauform und an die jeweilige materielle Beschaffenheit des Turboladers angepasst werden. Eine mangelnde Anpassung der Sensorausführung an die jeweilige Messsituation kann u. U. zu einer starken Abnahme der Messgenauigkeit führen.

Aus der US 4,021,681 ist eine Sensorschaltung bekannt, mit der die Drehgeschwindigkeit eines ferromagnetischen Zahnrads berührungslos gemessen werden kann. Dazu ist am Gehäuse des Zahnrads zwischen dem Zahnrad und einem Dauermagneten eine Spule angebracht, die zusammen mit einer parallel geschalteten Kapazität einen Schwingkreis bildet. Durch den unterschiedlichen Abstand der Zähne des Zahnrads und deren Zwischenräume von der Spule ändert sich der magnetische Fluss durch die Spule. Damit verändert sich bei einer Drehbewegung des Zahnrads die Resonanzfrequenz der aus Spule und parallel geschalteter Kapazität bestehenden Sensoranordnung. Die Sensoranordnung wird mit einer Speisespannung beaufschlagt, deren Frequenz durch eine PLL (Phase Locked Loop)-Schaltung nahe der Resonanzfrequenz der Sensoranordnung gehalten wird. Das Signal am Ausgang des Phasenkomperators in der PLL-Schaltung wird einer Ausgangsstufe zugeführt, die daraus eine von der Drehgeschwindigkeit des Zahnrads abhängige Spannung erzeugt.

US 4,088,022 zeigt einen berührungslosen Durchflussmesser. In einem Messrohr ist eine Messturbine angeordnet, deren Schaufeln bei einer Drehbewegung der Turbine an einer Spule vorbeibewegt werden. Die Spule ist zusammen mit Kapazitäten Bestandteil eines Schwingkreises, der in Folge der vorbeibewegten Turbinenschaufeln verstimmt wird. Der Schwingkreis bildet in Verbindung mit seiner Beschaltung einen Oszillator, dessen Ausgangssignal einer PLL-Schaltung zugeführt wird. Über eine Filterkette wird das Ausgangssignal der PLL-Schaltung aufbereitet und ein die Durchflussmenge durch das Messrohr repräsentierendes Ausgabesignal erzeugt. Mit jeder an der Spule vorbeibewegten Turbinenschaufel wird das Ausgangssignal der PLL-Schaltung moduliert. Aus der zeitlichen Abfolge der Modulationen wird auf die Drehgeschwindigkeit der Turbine geschlossen und der Durchfluss durch das Messrohr bestimmt.

Andere auf einen VCO (Voltage Controlled Oscillator) basierende Sensorschaltungen sind aus den Druckschriften US 4,459,561, US 5,041,856 und DE 26 49 366 A1 bekannt.

Die DE 42 12 363 A1, WO 98/05919 A1, EP 0 697 769 A1 und EP 0 759 657 A1 offenbaren Sensorschaltungen, bei denen eine Sensorspule mit einer Kapazität einen Schwingkreis bilden.

Keine der bekannten Verfahren und Vorrichtungen ist jedoch zur Vermessung schnell rotierender Turbinen geeignet

Der vorliegenden Erfindung liegt die Aufgabe zugrunde, ein Verfahren und eine Vorrichtung zur berührungslosen Drehzahlmessung der eingangs genannten Art anzugeben, mit dem/der eine Drehzahlmessung für eine Vielzahl unterschiedlicher Geometrien der zu untersuchenden Objekte mit nahezu gleich bleibender Empfindlichkeit möglich ist.

Das erfindungsgemäße Verfahren zur berührungslosen Drehzahlmessung löst die voranstehende Aufgabe durch die Merkmale des Patentanspruchs 1. Danach ist ein solches Verfahren dadurch gekennzeichnet, dass die Resonanzfrequenz des Schwingkreises und/oder die Erregerfrequenz des Schwingkreises als Reaktion auf langsame Änderungen der Resonanzfrequenz derart beeinflusst werden, dass der Schwingkreis stets mit seiner Resonanzfrequenz oder mit einer Frequenz nahe der Resonanzfrequenz angeregt wird, und dass schnelle Änderungen, die durch die einzelnen Schaufeln der Turbine hervorgerufenen werden, als Messsignal für die Drehzahlmessung erfasst werden.

In vorrichtungsmäßiger Hinsicht wird die eingangs genannte Aufgabe durch die Merkmale des Patentanspruchs 9 gelöst. Hiernach ist eine Vorrichtung zur berührungslosen Drehzahlmessung dadurch gekennzeichnet, dass die Resonanzfrequenz des Schwingkreises und/oder die Erregerfrequenz des Schwingkreises als Reaktion auf langsame Änderungen der Resonanzfrequenz derart beeinflussbar sind, dass der Schwingkreis stets mit seiner Resonanzfrequenz oder mit einer Frequenz nahe der Resonanzfrequenz angeregt wird und dass schnelle Änderungen, die durch die einzelnen Schaufeln der Turbine hervorgerufenen werden, als Messsignal für die Drehzahlmessung erfassbar sind.

Erfindungsgemäß ist erkannt worden, dass die Empfindlichkeit einer Drehzahlmessung in hohem Maße davon abhängig ist, dass der Näherungssensor optimal an die Geometrie und die Materialbeschaffenheit des zu untersuchenden Objekts angepasst ist. Darüber hinaus ist erkannt worden, dass es in Abkehr von der bisherigen Praxis, wonach für Turbolader mit unterschiedlicher Geometrie und Dimensionierung eine Vielzahl unterschiedlicher Sensorausführungen benötigt wird, möglich ist, mit einer einzigen Sensorausführung eine möglichst gleich bleibend hohe Empfindlichkeit für Messungen an unterschiedlichen Turboladern zu erreichen. Erfindungsgemäß wird dazu die Resonanzfrequenz und/oder die Erregerfrequenz des Schwingkreises derart beeinflusst, dass der Schwingkreis stets mit seiner Resonanzfrequenz oder zumindest mit einer Frequenz nahe der Resonanzfrequenz angeregt wird. Somit arbeitet der Näherungssensor stets im Bereich seiner größten Empfindlichkeit. Einflüsse von Herstellungstoleranzen, unterschiedlichen Einbausituationen, durch den Einbau verursachte Induktivitätstoleranzen, langsame temperaturbedingte Änderungen, Langzeiteffekte, etc. werden somit ausgeglichen und eliminiert, während schnelle Änderungen, die durch die einzelnen Schaufeln beim Passieren hervorgerufen werden, erfasst werden.

In einer besonders bevorzugten Ausführungsform erfolgt die Beeinflussung der Resonanzfrequenz und/oder der Erregerfrequenz im Sinne einer Regelung. Eine Regelung bietet den Vorteil, dass mit einer geeigneten Regelgröße ohne Eingriff von außen eine Anpassung der Resonanzfrequenz mit hoher Genauigkeit und hinreichender Geschwindigkeit durchführbar ist.

Der Schwingkreis wird in vorteilhafter Weise durch einen Oszillator angeregt. Zur Erfassung der Änderung der Resonanzfrequenz kann der Phasenunterschied zwischen dem Oszillatorsignal und dem Signal am Schwingkreis gemessen werden.

Im Konkreten kann der Phasenunterschied mittels eines Phasendetektors gemessen werden, welcher im einfachsten Fall als Multiplizier ausgebildet sein könnte. Als Messsignal kann dann ein Phasendifferenzsignal bereitgestellt werden.

Das Phasendifferenzsignal kann mit einem Sollwert verglichen werden, der mit einem Schaltungsteil erzeugt wird. In vorteilhafter Weise wird ein Sollwert bereitgestellt, der einem Phasenunterschied Null entspricht.

Im Hinblick auf eine besonders hohe Empfindlichkeit ist insbesondere die Spulengüte im Schwingkreis zu berücksichtigen. Dabei ist es von Vorteil, die Sensorspule und den -kondensator so zu wählen, dass eine durch die Annäherung der Turbinenschaufel an den Näherungssensor hervorgerufene Änderung der Resonanzfrequenz möglichst groß ist.

In der Praxis liegen die Signaldauern, die bei höchster zu erfassender Drehzahl, kleinstem Sensor, schmalster Schaufel und großem Detektionsabstand auftreten, in etwa im Bereich einer Mikrosekunde. Um bei der Demodulation des Signals am Schwingkreis eine Signaländerung innerhalb dieses Zeitraums von einer Mikrosekunde problemlos erfassen zu können, ist es von Vorteil, die Resonanzfrequenz entsprechend hoch, d. h. in vorteilhafter Weise größer als 1 MHz, zu wählen. Im praktischen Betrieb hat sich eine Resonanzfrequenz von ca. 3 MHz als geeignet erwiesen.

Im Hinblick auf die Nachregelung der Resonanzfrequenz des Schwingkreises sind verschiedene Ansätze denkbar. So kann beispielsweise eine steuerbare Kapazität in den Schwingkreis integriert werden, die in Abhängigkeit des Vergleichswerts, der aus dem Vergleich zwischen dem Phasendifferenzsignal und dem Sollwert resultiert, verändert werden kann. Bei der steuerbaren Kapazität kann es sich beispielsweise um eine Kapazitätsdiode handeln.

Eine weitere Möglichkeit zur Nachregelung der Resonanzfrequenz des Schwingkreises besteht darin, eine steuerbare Induktivität zuzuschalten, die - wie zuvor in Bezug auf die steuerbare Kapazität beschrieben - ebenfalls verändert werden kann. Beide Möglichkeiten, steuerbare Kapazität und steuerbare Induktivität, bieten den Vorteil einer kontinuierlichen Regelung. Sowohl die steuerbare Induktivität als auch die steuerbare Kapazität können sowohl im Sinne einer Parallel- als auch im Sinne einer Reihenschaltung in den Schwingkreis integriert sein.

Im Rahmen einer weiteren konkreten Ausführungsform können zusätzliche Kondensatoren mit nicht veränderbaren Kapazitäten und/oder Spulen mit nicht veränderbaren Induktivitäten zu- oder weggeschaltet werden. Das Zu- bzw. Wegschalten erfolgt ebenfalls in Abhängigkeit des Vergleichswerts zwischen Phasendifferenzsignal und Sollwert. Hierdurch ist eine Regelung der Resonanzfrequenz in diskreten Stufen möglich. Auch bei dieser Variante sind jeweils Parallel- bzw. Serienschaltungen möglich.

Neben der Resonanzfrequenz kann auch die Erregerfrequenz des Schwingkreises in Abhängigkeit des Vergleichswerts zwischen Phasendifferenzsignal und Sollwert verändert werden, wobei der Oszillator hierzu im Konkreten als spannungs- oder stromgesteuerter Oszillator ausgeführt sein kann. Alternativ kann es sich bei dem Oszillator um einen Digitalen Signalprozessor (DSP) handeln. Aufgrund der hohen Auflösung eines DSP's kann die Erregerfrequenz des Schwingkreises mit hoher Genauigkeit angepasst werden. Gleiches gilt für eine Ausführung des Oszillators als DDS (Direct Digital Synthesis)-Generator.

Es gibt nun verschiedene Möglichkeit, die Lehre der vorliegenden Erfindung in vorteilhafter Weise auszugestalten und weiterzubilden. Dazu ist einerseits auf die den Patentansprüchen 1 und 14 nachgeordneten Ansprüchen andererseits auf die nachfolgende Erläuterung von Ausführungsbeispielen der Erfindung anhand der Zeichnung zu verweisen. In Verbindung mit der Erläuterung der bevorzugten Ausführungsbeispiele der Erfindung anhand der Zeichnung werden auch im allgemeinen bevorzugte Ausgestaltungen und Weiterbildungen der Lehre erläutert. In der Zeichnung zeigt
- Fig. 1: in einer schematischen Ansicht den prinzipiellen Aufbau einer Anordnung zur berührungslosen Drehzahlmessung mit einem nach dem Wirbelstromprinzip arbeitenden Näherungssensor,
- Fig. 2: in einem Blockschaltbild, schematisch, ein erstes Ausführungsbeispiel einer erfindungsgemäßen Vorrichtung mit einer steuerbaren Kapazität,
- Fig. 3: in einem Blockschaltbild, schematisch, ein zweites Ausführungsbeispiel einer erfindungsgemäßen Vorrichtung mit einer steuerbaren Induktivität,
- Fig. 4: in einem Blockschaltbild, schematisch, ein drittes Ausführungsbeispiel einer erfindungsgemäßen Vorrichtung mit zuschaltbaren Kapazitäten,
- Fig. 5: in einem Blockschaltbild, schematisch, ein viertes Ausführungsbeispiel einer erfindungsgemäßen Vorrichtung mit zuschaltbaren Induktivitäten,
- Fig. 6: in einem Blockschaltbild, schematisch, ein fünftes Ausführungsbeispiel einer erfindungsgemäßen Vorrichtung mit einem steuerbaren Oszillator und
- Fig. 7: in einem Blockschaltbild, schematisch, ein sechstes Ausführungsbeispiel einer erfindungsgemäßen Vorrichtung mit einem Digitalen Signalprozessor.

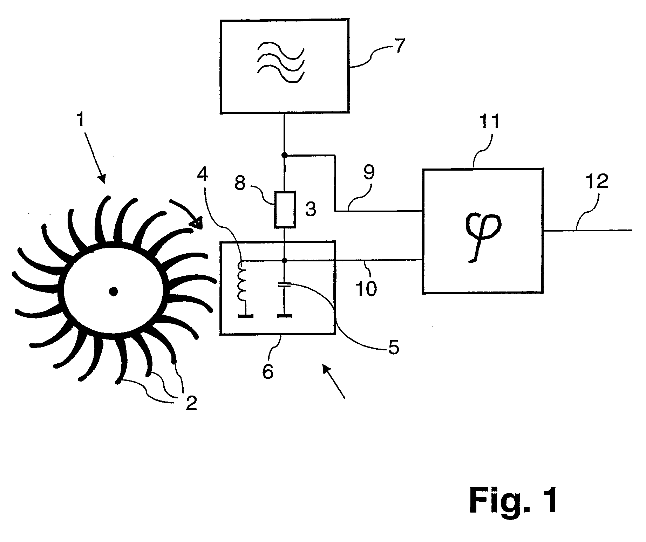

Fig. 1 zeigt schematisch den prinzipiellen Aufbau einer Anordnung zur berührungslosen Drehzahlmessung nach dem Wirbelstromprinzip. Dargestellt ist eine rotierende Turbine 1 eines Turboladers. Beabstandet zu den Schaufeln 2 der Turbine 1 ist ein Näherungssensor 3 positioniert, der eine Spule 4 und einen Parallelkondensator 5 umfasst. Spule 4 und Parallelkondensator 5 bilden einen Schwingkreis 6, dessen Resonanzfrequenz so gewählt ist, dass eine Resonanzfrequenzänderung, die durch Annäherung der Laderschaufeln 2 hervorgerufen wird, möglichst groß ist.

Der Schwingkreis 6 wird durch einen Oszillator 7 angeregt. Die Speisung des Schwingkreises 6 durch das Oszillatorsignal erfolgt über eine Impedanz 8. Die Impedanz 8 ist vorzugsweise durch einen ohmschen Widerstand realisiert. Es können aber auch Induktivitäten oder Kapazitäten oder Kombinationen verschiedener Impedanzen eingesetzt werden.

Zur Erfassung der Resonanzfrequenzänderung wird der Phasenunterschied zwischen dem Oszillatorsignal 9 und dem Signal 10 am Schwingkreis 6 mit Hilfe eines Phasendetektors 11 gemessen. Der Phasendetektor 11 ist als Analogmultiplizierer ausgeführt. Am Ausgang des Phasendetektors 11 wird ein Phasendifferenzsignal 12 zur Weiterverarbeitung bereitgestellt.

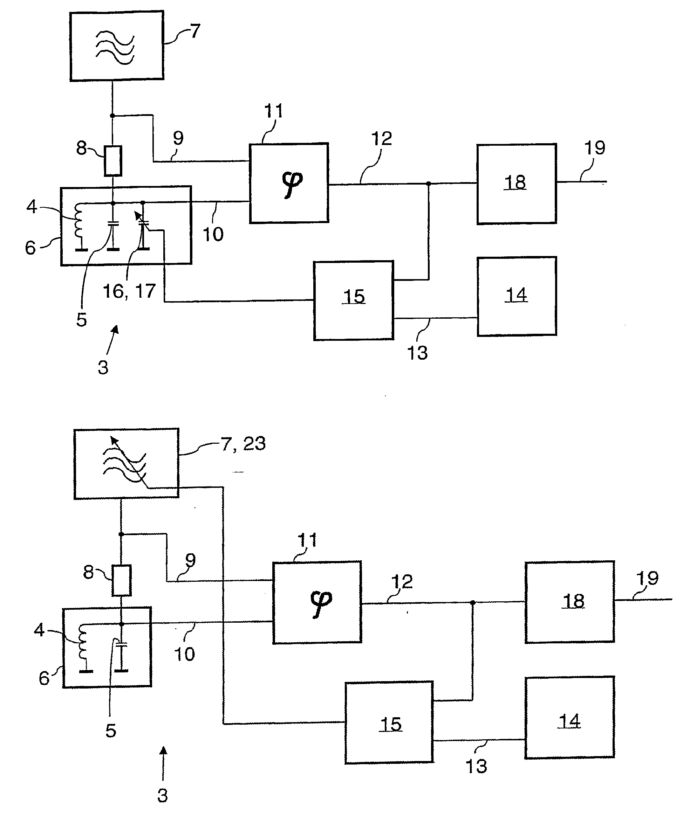

Fig. 2 zeigt schematisch ein Blockschaltbild eines ersten Ausführungsbeispiels einer erfindungsgemäßen Vorrichtung zur berührungslosen Drehzahlmessung. Gleiche Bauteile wie in Fig. 1 sind durch gleiche Bezugszeichen gekennzeichnet. Das am Ausgang des Phasendetektors 11 bereitgestellte Phasendifferenzsignal 12 wird mit einem Sollwert 13 verglichen. Der Sollwert 13 wird mit Hilfe eines Schaltungsteils 14 erzeugt und entspricht dem Phasenunterschied Null. Eine Regel- bzw. Steuerschaltung 15 regelt bzw. steuert bei Abweichungen des Phasendifferenzsignals 12 vom Sollwert 13 die Resonanzfrequenz des Schwingkreises 6 nach, bis der Phasenunterschied wieder Null bzw. nahe Null ist. Beim Passieren der einzelnen Schaufeln 2 der Turbine 1 im normalen Betriebsfall ergibt sich eine mittlere Phasenabweichung, die ebenfalls durch die Regel- bzw. Steuerschaltung 15 auf Null abgeglichen wird. Somit stellt sich automatisch immer die größtmögliche Empfindlichkeit ein, unabhängig von allen im jeweiligen konkreten Einzelfall wirkenden Einflüssen. Das Messverfahren erlaubt es somit, einen Näherungssensor 3 mit verhältnismäßig kleiner Bauform in einer Vielzahl unterschiedlicher Turbolader zu verwenden.

Zur Veränderung der Resonanzfrequenz des Schwingkreises 6 ist der Schwingkreis 6 um eine steuerbare Kapazität 16 ergänzt. Die steuerbare Kapazität 16, die als Kapazitätsdiode 17 ausgeführt ist, ist in dem dargestellten Ausführungsbeispiel parallel geschaltet, wobei eine Schaltung in Serie ebenfalls denkbar ist. Die erforderliche Regel- bzw. Steuerzeit liegt erfahrungsgemäß optimal im Bereich von ca. 0,1 bis 1 Sekunde. Schnelle Phasenänderungen, die beim Passieren einer Schaufel 2 auftreten, werden durch eine geeignete Schaltung 18 zum eigentlichen Messsignal 19 weiterverarbeitet.

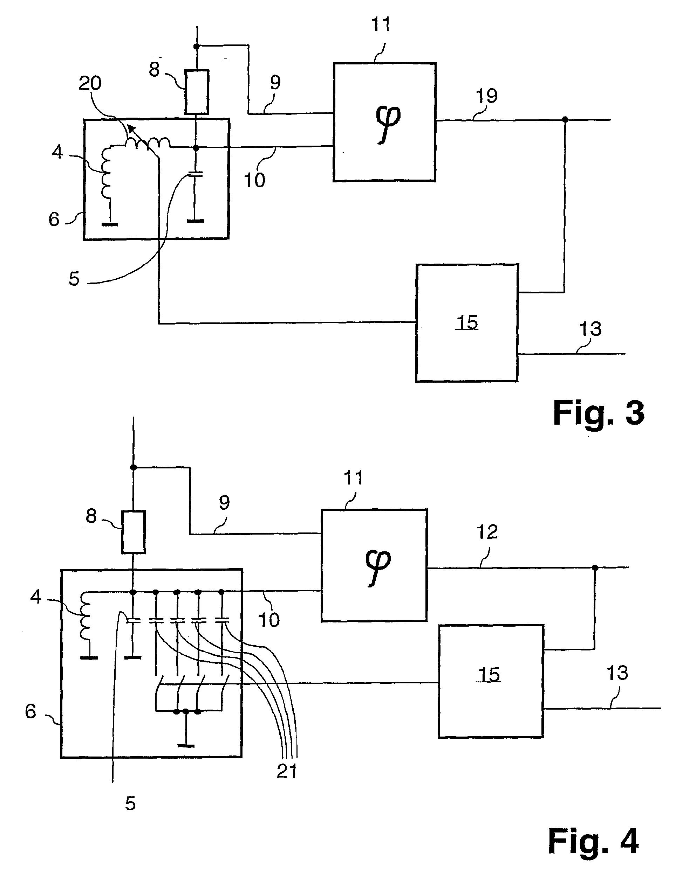

Fig. 3 zeigt ausschnitthaft prinzipiell den gleichen Aufbau wie in Fig. 2. Im Unterschied zu der Ausführungsform gemäß Fig. 2 erfolgt die Regelung bzw. die Steuerung der Resonanzfrequenz des Schwingkreises 6 nicht über eine Kapazitätsdiode 17, sondern über eine steuerbare Induktivität 20. Die Induktivität 20 ist in Reihe geschaltet, wobei hier eine Parallelschaltung ebenfalls möglich ist.

Fig. 4 zeigt ein weiteres Ausführungsbeispiel, bei dem ebenfalls die Resonanzfrequenz des Schwingkreises 6 geregelt bzw. gesteuert wird. Im Unterschied zu den Ausführungsbeispielen gemäß Fig. 2 und Fig. 3, bei denen eine kontinuierliche Veränderung der Resonanzfrequenz des Schwingkreises 6 möglich ist, ist in dem in Fig. 4 gezeigten Ausführungsbeispiel eine Veränderung der Resonanzfrequenz in diskreten Schritten realisiert. Dazu ist der Schwingkreis 6 um eine Vielzahl von Kondensatoren 21 ergänzt, deren Kapazitäten jeweils unveränderbar sind. Zur Nachregelung der Resonanzfrequenz des Schwingkreises 6 können - in Abhängigkeit von der detektierten Phasenabweichung - einzelne oder mehrere der Kondensatoren 21 zu- bzw. weggeschaltet werden. Dargestellt ist eine Parallelschaltung der Kondensatoren 21 wobei auch hier wiederum eine Serienschaltung bzw. eine Kombination aus Parallel- und Serienschaltung realisierbar ist.

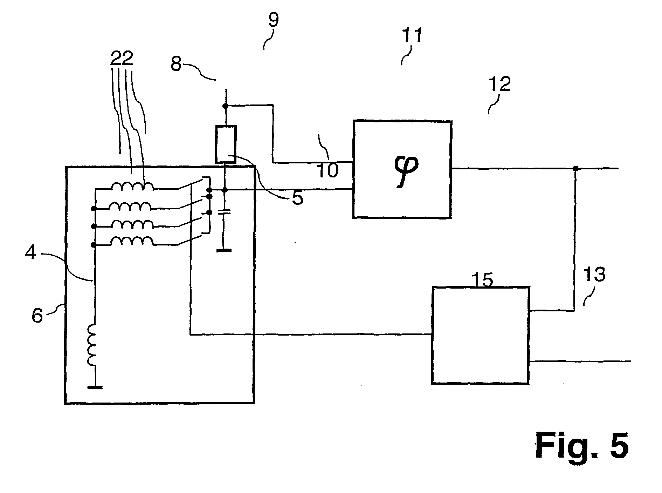

Fig. 5 zeigt prinzipiell den gleichen Ansatz wie bei dem Ausführungsbeispiel gemäß Fig. 4, mit der Maßgabe, dass anstelle der Kondensatoren 21 zusätzliche Spulen 22 zu- bzw. weggeschaltet werden können. Eine Ausführungsform, bei der zuschaltbare Kondensatoren 21 und zuschaltbare Spulen 22 kombiniert sind, ist ebenfalls denkbar, wesentlich ist jedenfalls, dass durch Zu- bzw. Wegschalten von Kondensatoren 21 und/oder Spulen 22 die Resonanzfrequenz des Schwingkreises 6 - in möglichst feinen Schritten - veränderbar ist.

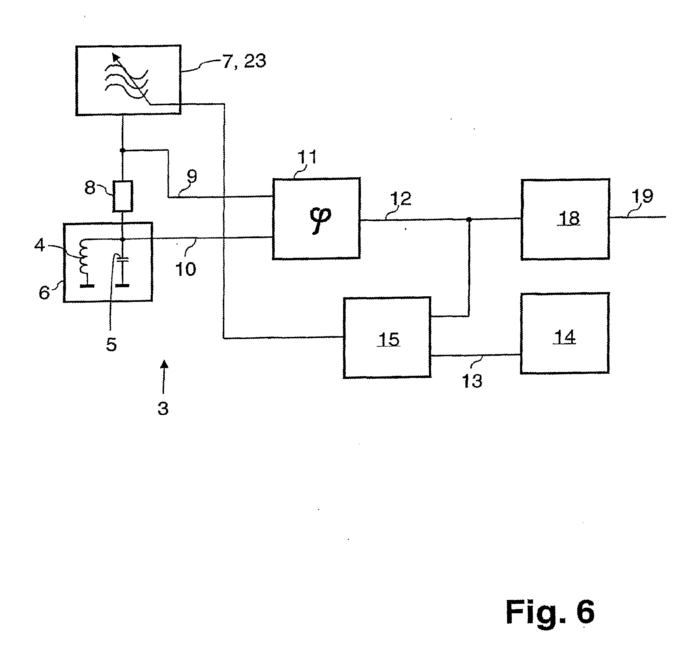

Fig. 6 zeigt ein Ausführungsbeispiel, bei dem nicht die Resonanzfrequenz des Schwingkreises 6, sondern die Oszillatorfrequenz, mit der der Schwingkreis 6 erregt wird, verändert wird. Dabei ist der Oszillator 7 als spannungsgesteuerter Oszillator (VCO) 23 ausgebildet. Ansonsten folgt das Messverfahren dem in Zusammenhang mit Fig. 2 beschriebenen Verfahren.

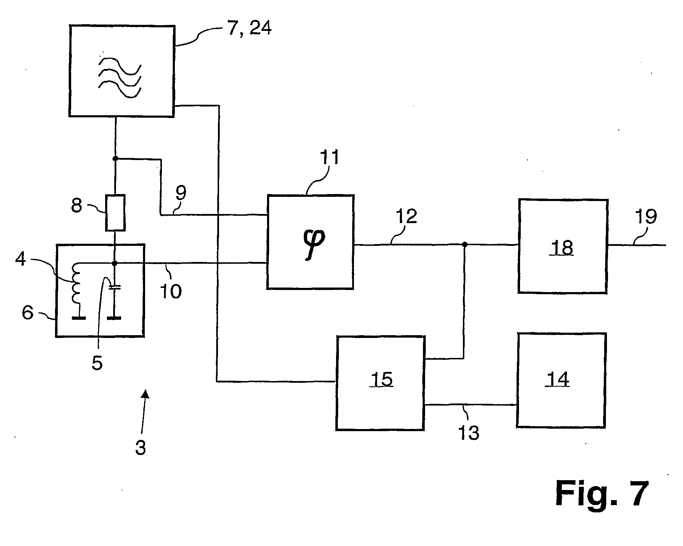

Fig. 7 zeigt schließlich eine Ausführungsform, bei der zur Erregung des Schwingkreises 6 ein digitaler Oszillator 7 eingesetzt wird. Im Konkreten ist der digitale Oszillator 7 als Digitaler Signalprozessor (DSP) 24 ausgeführt. Der DSP 24 erlaubt es, die Frequenzanpassung mit hoher Auflösung durchzuführen. Alternativ kann der digitale Oszillator 7 beispielsweise auch als DDS-Signalgenerator ausgeführt sein.

Schließlich sei angemerkt, dass die voranstehend erörterten Ausführungsbeispiele die beanspruchte Lehre lediglich erläutern, diese jedoch nicht auf die Ausführungsbeispiele einschränken.

## Patentansprüche

1. Verfahren zur berührungslosen Drehzahlmessung von Turbinen mit einem nach dem Wirbelstromprinzip arbeitenden Näherungssensor (3), wobei der Näherungssensor (3) eine Induktivität und eine parallel geschaltete Kapazität umfasst, die einen von außen erregbaren Schwingkreis (6) bilden, und wobei die Resonanzfrequenz des Schwingkreises (6) bei Annäherung eines Messobjekts an den Näherungssensor (3) eine nachweisbare Änderung erfährt,
**dadurch gekennzeichnet, dass** die Resonanzfrequenz des Schwingkreises (6) und/oder die Erregerfrequenz des Schwingkreises (6) als Reaktion auf langsame Änderungen der Resonanzfrequenz derart beeinflusst werden, dass der Schwingkreis (6) stets mit seiner Resonanzfrequenz oder mit einer Frequenz nahe der Resonanzfrequenz angeregt wird, und dass schnelle Änderungen, die durch die einzelnen Schaufeln der Turbine hervorgerufen werden, als Messsignal für die Drehzahlmessung erfasst werden.

2. Verfahren nach Anspruch 1, **dadurch gekennzeichnet, dass** die Beeinflussung im Sinne einer Regelung durchgeführt wird.

3. Verfahren nach Anspruch 1 oder 2, **dadurch gekennzeichnet, dass** der Schwingkreis (6) durch einen Oszillator (7) angeregt wird, wobei zur Erfassung der Änderung der Resonanzfrequenz der Phasenunterschied zwischen dem Oszillatorsignal (9) und dem Signal am Schwingkreis (10) gemessen wird, wobei der Phasenunterschied mittels eines Phasendetektors (11) gemessen wird und wobei am Ausgang des Phasendetektors (11) ein Phasendifferenzsignal (12) bereitgestellt wird.

4. Verfahren nach Anspruch 3, **dadurch gekennzeichnet, dass** das Phasendifferenzsignal (12) mit einem Sollwert (13) verglichen wird.

5. Verfahren nach Anspruch 4, **dadurch gekennzeichnet, dass** der Sollwert (13) dem Phasenunterschied Null entspricht.

6. Verfahren nach Anspruch 4 oder 5, **dadurch gekennzeichnet, dass** die Resonanzfrequenz in Abhängigkeit von der Abweichung des Phasendifferenzsignals (12) vom Sollwert (13) durch Verändern einer zugeschalteten steuerbaren Kapazität (16) und/oder durch Verändern einer zugeschalteten steuerbaren Induktivität (20) geregelt wird.

7. Verfahren nach einem der Ansprüche 4 bis 6, **dadurch gekennzeichnet, dass** die Resonanzfrequenz in Abhängigkeit von der Abweichung des Phasendifferenzsignals (12) vom Sollwert (13) durch Zu- und Wegschalten von zusätzlichen Kapazitäten (21) und/oder Induktivitäten (22) geregelt wird.

8. Verfahren nach einem der Ansprüche 4 bis 7, **dadurch gekennzeichnet, dass** die Erregerfrequenz in Abhängigkeit von der Abweichung des Phasendifferenzsignals (12) vom Sollwert (13) verändert wird.

9. Vorrichtung zur berührungslosen Drehzahlmessung von Turbinen mit einem nach dem Wirbelstromprinzip arbeitenden Näherungssensor (3), wobei der Näherungssensor (3) eine Induktivität (4) und eine parallel geschaltete Kapazität (5) umfasst, die einen von außen erregbaren Schwingkreis (6) bilden, und wobei die Resonanzfrequenz des Schwingkreises (6) bei Annäherung eines Messobjekts an den Näherungssensor (3) eine nachweisbare Änderung erfährt, vorzugsweise zur Anwendung eines Verfahrens nach einem der Ansprüche 1 bis 8,
**dadurch gekennzeichnet, dass** die Resonanzfrequenz des Schwingkreises (6) und/oder die Erregerfrequenz des Schwingkreises (6) als Reaktion auf langsame Änderungen der Resonanzfrequenz derart beeinflussbar sind, dass der Schwingkreis (6) stets mit seiner Resonanzfrequenz oder mit einer Frequenz nahe der Resonanzfrequenz angeregt wird, und dass schnelle Änderungen, die durch die einzelnen Schaufeln der Turbine hervorgerufen werden, als Messsignal für die Drehzahlmessung erfassbar sind.

10. Vorrichtung nach Anspruch 9, **gekennzeichnet durch** einen Oszillator (7) zur Anregung des Schwingkreises (6), wobei der Oszillator (7) spannungs- oder stromgesteuert ist.

11. Vorrichtung nach Anspruch 10, **dadurch gekennzeichnet, dass** der Oszillator (7) als DSP (Digitaler Signalprozessor) (24) oder als DDS-Signalgenerator ausgeführt ist.

12. Vorrichtung nach einem der Ansprüche 9 bis 11, **gekennzeichnet durch** eine steuerbare Kapazität (16) zur Nachregelung der Resonanzfrequenz des Schwingkreises (6).

13. Vorrichtung nach Anspruch 12, **dadurch gekennzeichnet, dass** die steuerbare Kapazität (16) als Kapazitätsdiode (17) ausgeführt ist.

14. Vorrichtung nach einem der Ansprüche 9 bis 13, **gekennzeichnet durch** eine steuerbare Induktivität (20) zur Nachregelung der Resonanzfrequenz des Schwingkreises (6).

15. Vorrichtung nach einem der Ansprüche 9 bis 14, **gekennzeichnet durch** zu- und wegschaltbare Kapazitäten (21) und/oder Induktivitäten (22) zur Nachregelung der Resonanzfrequenz des Schwingkreises (6).

## Claims

1. A method for contactless measurement of the rotational speed of turbines with a proximity sensor (3) operating according to the eddy current principle, the proximity sensor (3) comprising an inductor and a capacitor connected in parallel which form an externally excitable oscillating circuit (6), and the resonant frequency of the oscillating circuit (6) undergoing a detectable change when a measurement object approaches the proximity sensor (3),
**characterised in that** the resonant frequency of the oscillating circuit (6) and/or the excitation frequency of the oscillating circuit (6) are influenced in response to slow changes in the resonant frequency in such a manner that the oscillating circuit (6) is always excited with its resonant frequency or with a frequency close to the resonant frequency, and rapid changes which are caused by the individual blades of the turbine are detected as a measurement signal for measurement of the rotational speed.

2. A method according to claim 1, **characterised in that** the influencing is carried out in the sense of a closed-loop regulation procedure.

3. A method according to claim 1 or 2, **characterised in that** the oscillating circuit (6) is excited by an oscillator (7), the phase difference between the oscillator signal (9) and the signal at the oscillating circuit (10) being measured to detect the change in the resonant frequency, the phase difference being measured by means of a phase detector (11), and a phase difference signal (12) being supplied at the output of the phase detector (11).

4. A method according to claim 3, **characterised in that** the phase difference signal (12) is compared with a set point value (13).

5. A method according to claim 4, **characterised in that** the set point value (13) corresponds to the phase difference zero.

6. A method according to claim 4 or 5, **characterised in that** the resonant frequency is regulated as a function of the deviation of the phase difference signal (12) from the set point value (13) by changing a connected controllable capacitance (16) and/or by changing a connected controllable inductance (20).

7. A method according to any one of claims 4 to 6, **characterised in that** the resonant frequency is regulated as a function of the deviation of the phase difference signal (12) from the set point value (13) by connecting and disconnecting additional capacitors (21) and/or inductors (22).

8. A method according to any one of claims 4 to 7, **characterised in that** the excitation frequency is changed as a function of the deviation of the phase difference signal (12) from the set point value (13).

9. A device for contactless measurement of the rotational speed of turbines with a proximity sensor (3) operating according to the eddy current principle, the proximity sensor (3) comprising an inductor (4) and a capacitor (5) connected in parallel which form an externally excitable oscillating circuit (6), and the resonant frequency of the oscillating circuit (6) undergoing a detectable change when a measurement object approaches the proximity sensor (3), preferably for using a method according to any one of claims 1 to 8, **characterised in that** the resonant frequency of the oscillating circuit (6) and/or the excitation frequency of the oscillating circuit (6) may be influenced in response to slow changes in the resonant frequency in such a manner that the oscillating circuit (6) is always excited with its resonant frequency or with a frequency close to the resonant frequency, and rapid changes which are caused by the individual blades of the turbine may be detected as a measurement signal for measurement of the rotational speed.

10. A device according to claim 9, **characterised by** an oscillator (7) for exciting the oscillating circuit (6), the oscillator (7) being voltage-controlled or current-controlled.

11. A device according to claim 10, **characterised in that** the oscillator (7) is in the form of a DSP (digital signal processor) (24) or in the form of a DDS signal generator.

12. A device according to any one of claims 9 to 11, **characterised by** a controllable capacitor (16) for readjustment of the resonant frequency of the oscillating circuit (6).

13. A device according to claim 12, **characterised in that** the controllable capacitor (16) is in the form of a capacitance diode (17).

14. A device according to any one of claims 9 to 13, **characterised by** a controllable inductor (20) for readjustment of the resonant frequency of the oscillating circuit (6).

15. A device according to any one of claims 9 to 14, **characterised by** connectable and disconnectable capacitors (21) and/or inductors (22) for readjustment of the resonant frequency of the oscillating circuit (6).

## Revendications

1. Procédé de mesure sans contact de la vitesse de rotation de turbines comprenant un capteur de proximité (3) fonctionnant selon le principe des courants de Foucault, dans lequel le capteur de proximité (3) comprend une inductance et une capacité montée en parallèle qui forment un circuit oscillant (6) pouvant être excité depuis l'extérieur, et dans lequel la fréquence de résonance du circuit oscillant (6) subit un changement pouvant être démontré lorsqu'un objet à mesurer approche du capteur de proximité (3),
**caractérisé en ce que** la fréquence de résonance du circuit oscillant (6) et/ou la fréquence d'excitation du circuit oscillant (6) sont influencées, en réaction à des changements lents de la fréquence de résonance, de telle sorte que le circuit oscillant (6) est toujours excité par sa fréquence de résonance ou par une fréquence proche de la fréquence de résonance et que des changements rapides, qui sont provoqués par les pales individuelles de la turbine, sont détectés en tant que signal de mesure pour la mesure de la vitesse de rotation.

2. Procédé selon la revendication 1, **caractérisé en ce que** l'influence est réalisée dans le sens d'un réglage.

3. Procédé selon la revendication 1 ou 2, **caractérisé en ce que** le circuit oscillant (6) est excité par un oscillateur (7), étant entendu que pour détecter le changement de la fréquence de résonance, la différence de phase entre le signal de l'oscillateur (9) et le signal du circuit oscillant (10) est mesurée, étant entendu que la différence de phase est mesurée au moyen d'un détecteur de phase (11) et étant entendu qu'un signal de différence de phase (12) est fourni à la sortie du détecteur de phase (11).

4. Procédé selon la revendication 3, **caractérisé en ce que** le signal de différence de phase (12) est comparé à une valeur de consigne (13).

5. Procédé selon la revendication 4, **caractérisé en ce que** la valeur de consigne (13) correspond à la différence de phase nulle.

6. Procédé selon la revendication 4 ou 5, **caractérisé en ce que** la fréquence de résonance est réglée en fonction de l'écart du signal de différence de phase (12) par rapport à la valeur de consigne (13) en modifiant une capacité (16) contrôlée raccordée en circuit et/ou en modifiant une inductance (20) contrôlée raccordée en circuit.

7. Procédé selon l'une des revendications 4 à 6, **caractérisé en ce que** la fréquence de résonance est réglée en fonction de l'écart du signal de différence de phase (12) par rapport à la valeur de consigne (13) en raccordant et en débranchant du circuit des capacités (21) et/ou des inductances (22) supplémentaires.

8. Procédé selon l'une des revendications 4 à 7, **caractérisé en ce que** la fréquence d'excitation est modifiée en fonction de l'écart du signal de différence de phase (12) par rapport à la valeur de consigne (13).

9. Dispositif de mesure sans contact de la vitesse de rotation de turbines comprenant un capteur de proximité (3) fonctionnant selon le principe des courants de Foucault, dans lequel le capteur de proximité (3) comprend une inductance (4) et une capacité (5) montée en parallèle qui forment un circuit oscillant (6) pouvant être excité depuis l'extérieur, et dans lequel la fréquence de résonance du circuit oscillant (6) subit un changement pouvant être démontré lorsqu'un objet à mesurer approche du capteur de proximité (3), de préférence aux fins de la réalisation d'un procédé selon l'une des revendications 1 à 8, **caractérisé en ce que** la fréquence de résonance du circuit oscillant (6) et/ou la fréquence d'excitation du circuit oscillant (6) peuvent être influencées, en réaction à des changements lents de la fréquence de résonance, de telle sorte que le circuit oscillant (6) est toujours excité par sa fréquence de résonance ou par une fréquence proche de la fréquence de résonance et que des changements rapides, qui sont provoqués par les pales individuelles de la turbine, peuvent être détectés en tant que signal de mesure pour la mesure de la vitesse de rotation.

10. Dispositif selon la revendication 9, **caractérisé par** un oscillateur (7) destiné à exciter le circuit oscillant (6), étant entendu que l'oscillateur (7) est commandé en tension ou en courant.

11. Dispositif selon la revendication 10, **caractérisé en ce que** l'oscillateur (7) est réalisé comme processeur de signaux numériques (24) ou comme générateur de signaux DDS.

12. Dispositif selon l'une des revendications 9 à 11, **caractérisé par** une capacité (16) contrôlée destinée à ajuster le réglage de la fréquence de résonance du circuit oscillant (6).

13. Dispositif selon la revendication 12, **caractérisé en ce que** la capacité (16) contrôlée est réalisée comme diode à capacité variable (17).

14. Dispositif selon l'une des revendications 9 à 13, **caractérisé par** une inductance (20) contrôlée destinée à ajuster le réglage de la fréquence de résonance du circuit oscillant (6).

15. Dispositif selon l'une des revendications 9 à 14, **caractérisé par** des capacités (21) et/ou des inductances (22) pouvant être raccordées et débranchées du circuit afin d'ajuster le réglage de la fréquence de résonance du circuit oscillant (6).
